**Europäisches Patentamt**

**European Patent Office**

**Office européen des brevets**

(11) Veröffentlichungsnummer: **0 483 653 A2**

# EUROPÄISCHE PATENTANMELDUNG

(21) Anmeldenummer: **91118028.9**

(22) Anmeldetag: **23.10.91**

(51) Int. Cl.5: **H03M 13/00, G01D 5/34, G01B 11/02, F16H 59/02**

(30) Priorität: **31.10.90 US 606239**

(43) Veröffentlichungstag der Anmeldung:
**06.05.92 Patentblatt 92/19**

(84) Benannte Vertragsstaaten:
**DE ES FR GB IT SE**

(71) Anmelder: **DEERE & COMPANY**
**1 John Deere Road**
**Moline, Illinois 61265(US)**

(72) Erfinder: **Symonds, Dean Homer**
**Route 2, Box 120**
**Cherryvale, Kansas 67337(US)**

(74) Vertreter: **Feldmann, Bernhard et al**
**DEERE & COMPANY European Office Patent**
**Department Steubenstrasse 36-42**
**W-6800 Mannheim 1(DE)**

(54) **Lagekodierer mit Gray-Code.**

(57) Die Erfindung betrifft einen Lagekodierer zum Nachweis der Lage eines Teiles (12), welches zwischen mehreren Lagen bewegbar ist, mit mehreren Kodierelementen (30 - 38), die Kennungen aufweisen, welche eine Vielzahl aus mehreren Bits gebildeter Wörter eines Gray-Codes, die jeweils einer bestimmten Lage entsprechen, repräsentieren, wobei jedes Wort einmalig ist und nur einer der Lagen entspricht. Um durch Fehler eines Bits ausgelöste gefährliche Steuersignale zu unterdrücken, wird die Kennung so angeordnet, daß für jedes Wort des Codes durch Änderung lediglich eines Bits des die besondere Lage repräsentierenden Wortes ein Wort entsteht, das

a) identisch mit einem Wort ist, das eine Lage des bewegbaren Teiles repräsentiert, die unmittelbar benachbart zu der besonderen Lage ist, oder

b) sich von allen Wörtern, die eine mögliche Lage repräsentieren, unterscheidet.

FIG. 2

EP 0 483 653 A2

Die Erfindung betrifft einen Lagekodierer zum Nachweis der Lage eines Teiles, welches zwischen mehreren Lagen bewegbar ist, mit mehreren Kodierelementen, die Kennungen aufweisen, welche eine Vielzahl aus mehreren Bits gebildeter Wörter eines Gray-Codes, die jeweils einer bestimmten Lage entsprechen, repräsentieren, wobei jedes Wort einmalig ist und nur einer der Lagen entspricht.

Die Erfindung findet bevorzugt bei einem elektronischen Getriebesteuersystem Anwendung, wie es beispielsweise bei landwirtschaftlichen und Nutzfahrzeugen verwendet wird.

Üblicherweise enthält ein elektronisches Getriebesteuersystem eines viele Übersetzungsverhältnisse aufweisenden Fahrzeuggetriebes einen Gangwahlhebel sowie einen Linear- oder Rotationskodierer, welcher ein Signal oder einen Code abgibt, der die Lage des Hebels einer elektronischen Steuereinheit mitteilt. Der Kodierer steht mit einer elektrischen Steuereinheit über Leitungen oder Schaltkreise in Verbindung. Es ist bekannt, daß bei den Linear- oder Rotationskodierern sogenannte Gray-Codes verwendet werden, durch die eine mehrdeutige Ablesung vermieden werden kann, wenn die Bits bei den digitalen Wörtern unterschiedlich sind. Ein Gray-Code ist ein aus Bit-Einheiten (Codewörtern) aufgebauter Binärcode mit der besonderen Eigenschaft, daß sich zwei benachbarte Codewörter nur in einer einzigen Binärstelle unterscheiden. Das bedeutet, daß Wörter, die benachbarten Positionen zugeordnet sind, bis auf einen Bit identisch sind. Der Gray-Code, der überzählige Bits enthalten kann, ist besonders für Abtaster geeignet, da keine Sprünge über mehrere Binärstellen wie bei anderen Binärcodes auftreten. Tritt ein Fehler in Leitungen oder Schaltkreisen auf, so können sich jedoch ein oder mehrere Bits des von der Steuereinheit empfangenen digitalen Wortes ändern. Es kann jedoch angenommen werden, daß durch einen typischen Fehler lediglich ein einzelnes Bit beeinflußt wird. Solch eine Änderung lediglich eines Bits wird bei einem üblichen Gray-Code nicht als Fehler erkannt. Er kann jedoch das von der Steuereinheit empfangene Wort so beeinflussen, daß es in ein Wort verändert wird, welches eine erhebliche Änderung der Position des Gangwahlhebels darstellt. Dies kann bei einem Getriebe mit mehreren Vorwärts- und Rückwärtsgängen gefährlich sein. Bei einem Getriebe mit acht Vorwärts- und vier Rückwärtsgängen, bei dem sich der Gangwahlhebel ursprünglich in einem hohen Vorwärtsgang befindet, wäre es gefährlich, wenn durch einen Fehler nur eines Bits das dem hohen Vorwärtsgang entsprechende digitale Wort in ein anderes Wort geändert wird, welches einem Rückwärtsgang entspricht.

Die der Erfindung zugrunde liegende Aufgabe wird darin gesehen, einen Kodierer der eingangs genannten Art anzugeben, bei dem ein Fehler in einem einzelnen Bit in einem durch den Kodierer erzeugten Wort nicht zu einer gefährlichen Situation, beispielsweise einem gefährlichen Umschalten eines Getriebes führt.

Die Aufgabe wird erfindungsgemäß durch die Lehre des Patentanspruchs gelöst. Demgemäß enthält ein Lagekodierer mehrere kodierte Elemente oder Scheiben. Den Kennungen der Elemente sind Bits zugeordnet, die zu Wörtern eines digitalen Gray-Codes zusammengesetzt sind. Jede Scheibe ist mechanisch mit einem Hebel oder einem verstellbaren Teil verbunden. Ein Sensor ist derart in der Nähe jeder Scheibe angeordnet, daß er digitale Signale in Abhängigkeit von den Kennungen der Kodierelemente erzeugt. Die Kennungen sind derart angeordnet, daß im Falle, daß lediglich ein Bit irgend eines Wortes geändert wird, das geänderte Wort entweder mit einem Wort identisch ist, welches einer benachbarten Position des Hebels entspricht, oder verschieden von allen Worten ist, welche irgend einer Position des Hebels entsprechen (unzulässiges Wort).

Anhand der Zeichnung, die ein Ausführungsbeispiel der Erfindung zeigt, werden nachfolgend die Erfindung sowie weitere Vorteile und vorteilhafte Weiterbildungen und Ausgestaltungen der Erfindung näher beschrieben und erläutert.

Es zeigt:

Fig. 1       die vereinfachte schematische Darstellung einer Gangwahlvorrichtung, welche mit einem Lagekodierer in Verbindung steht,

Fig. 2       die vereinfachte Darstellung eines erfindungsgemäßen Lagekodierers und

Fig. 3a bis 3e       schematische Diagramme von gezahnten Scheiben und zugeordneten Sensoren, welche verwendet werden können, um die Bitfolge des modifizierten Gray-Codes der vorliegenden Erfindung zu erzeugen.

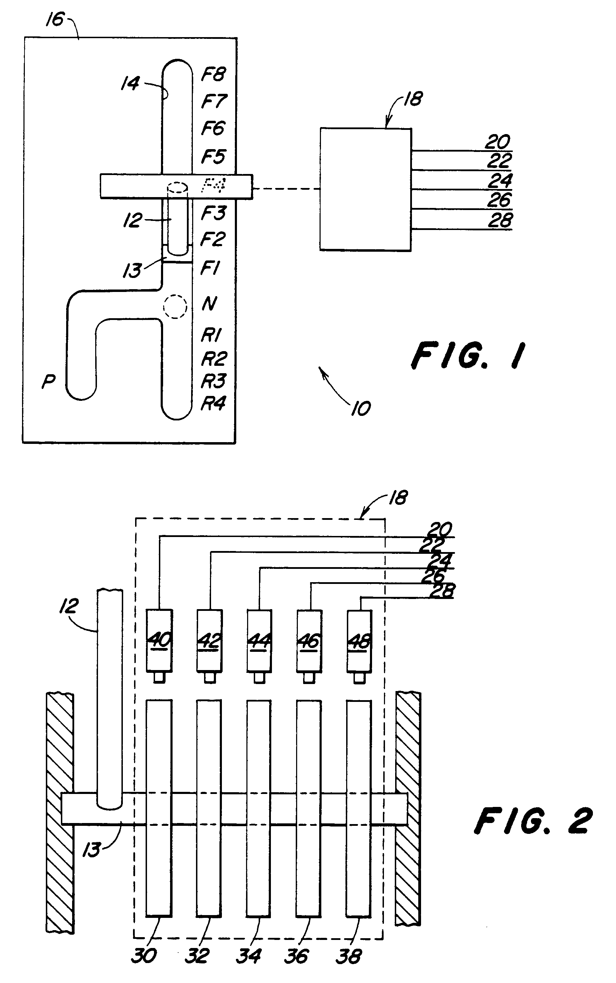

Die in Fig. 1 dargestellte Gangwahlvorrichtung 10 enthält einen handbetätigbaren Hebel 12, welcher um die Achse einer Welle 13 verschwenkbar ist und sich damit auf mehrere Positionen in einem Schlitz 14 eines Führungsgehäuses 16 einstellen läßt. Der Hebel 12 steht mit einem Kodierer 18 in Verbindung, welcher über die Leitungen 20 - 28 Signale ausgibt, durch die die Lage des Hebels 12 dargestellt wird. Die Leitungen 20 - 28 können mit einer nicht dargestellten elektronischen Steuereinheit eines Getriebeumschaltsteuersystems verbunden sein. Das Getriebe, das Umschaltsystem und die elektronische Steuereinheit sind nicht dargestellt, da sie nicht Gegenstand der vorliegenden Erfindung sind, welche sich lediglich auf den Kodierer 18 und die durch den Kodierer 18 erzeugten Signale oder Codes bezieht.

Gemäß Fig. 2 enthält der Kodierer 18 mehrere Kodierelemente oder Scheiben 30 - 38, die auf der Welle 13 drehfest montiert sind. Die Welle 13 wird durch eine Verstellung des Hebels 12 verdreht. Mehrere Sensoren 40 - 48 sind derart angeordnet, daß sich jeder Sensor benachbart zum Umfang eines zugehörigen Kodierelementes bzw. einer Scheibe 30 - 38 befindet. Bei den Sensoren kann es sich beispielsweise um Reluktanzsensoren, Permanentmagnetspannungsaufnehmer oder Mikroschalter handeln. Letztere haben Betätigungselemente, die mit der Umfangsfläche der Kodierelemente oder Scheiben 30 - 38 in Eingriff treten.

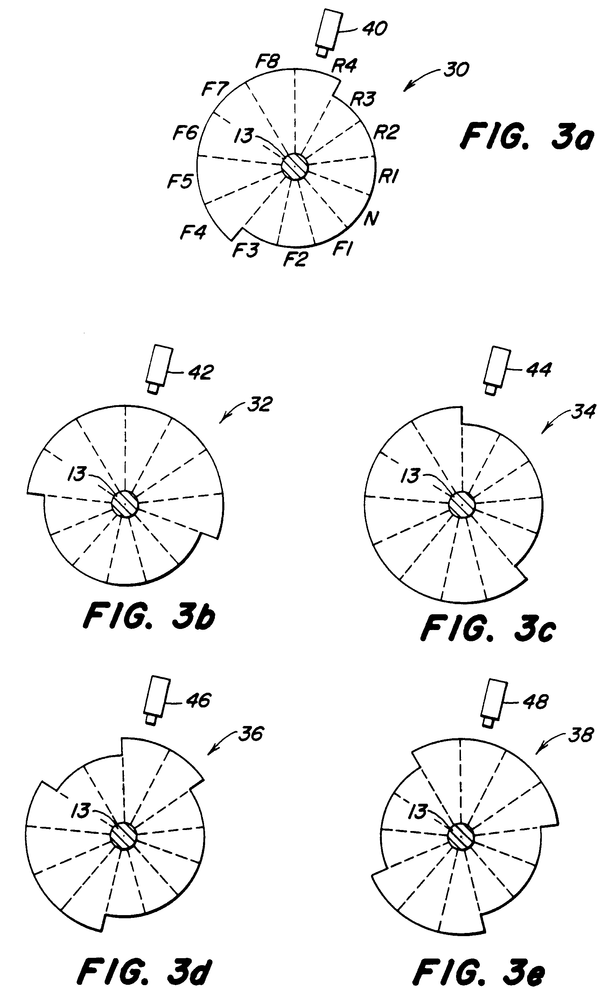

Gemäß den Figuren 3a - 3e läßt sich jede Scheibe 30 - 38 gedanklich in mehrere Segmente unterteilen, deren Anzahl gleich der möglichen Zahl der unterschiedlichen Lagen des Hebels 12 ist. Im vorliegenden Fall ist der Hebel 12 beispielsweise zwischen dreizehn Lagen verstellbar, welche acht Vorwärtsgangpositionen F1 - F8, vier Rückwärtsgangpositionen R1 - R4 und eine Neutralposition N umfassen. Jede der Scheiben 30 - 38 hat auf ihrem Umfang Zähne und Ausnehmungen. Jeder Sensor 40 -48 erzeugt ein einer logischen "1" entsprechendes Signal, wenn sich ein Zahn im Erfassungsbereich des Sensors 40 - 48 befindet, und ein einer logischen "0" entsprechendes Signal, wenn sich eine Ausnehmung im Erfassungsbereich des Sensors 40 - 48 befindet. Bei den Sensoren 40 - 48 handelt es sich vorzugsweise um Hall-Sensoren, die in bekannter Weise im Zusammenhang mit gezahnten Rädern oder lineargezahnten Elementen verwendet werden, wobei besagte Elemente aus ferromagnetischem oder anderem Material bestehen, das eine Änderung der elektrischen Eigenschaften des Sensors hervorruft.

Die Zähne und Ausnehmungen bilden Kennungen, die durch Bits binärer Wörter darstellt werden, wobei aus den Wörtern ein Code gebildet wird, der die Lage der Scheibe und damit die Lage des Hebels 12 repräsentiert. Die Größe der Zähne und Ausnehmungen, beziehungsweise deren Abstand, geht aus den Figuren 3a - 3e hervor. Jede Lage des Hebels 12 wird somit durch ein einziges aus fünf Bits bestehendes Wort repräsentiert.

In der Tabelle I sind Worte eines Fünf-Bit-Gray-Codes angegeben, deren Bitfolge der in den Figuren 3a - 3e dargestellten Anordnung der Sensoren und Scheiben entspricht. Aus der Tabelle I ist ersichtlich, daß diese Fünf-Bit-Wörter einen Code vom Gray-Typ bilden, bei dem sich zueinander benachbarte Wörter lediglich in jeweils einem Bit unterscheiden. Das heißt, benachbarte Wörter sind identisch bis auf ein Bit. Aus Tabelle I geht ferner hervor, daß die dort dargestellten Wörter ein zusätzliches neues Kennzeichen aufweisen. Insbesondere ist dann, wenn lediglich ein Bit irgend eines Wortes geändert wird, das modifierte Wort entweder identisch mit einem Wort, das einer benachbarten Lage des Hebels 12 entspricht, oder es unterscheidet sich von allen Wörtern, durch die eine mögliche Lage des Hebels 12 repräsentiert wird (unzulässiges Wort).

EP 0 483 653 A2

**Tabelle I**

**Scheibe/Code**

| Gang | 30 | 32 | 34 | 36 | 38 |
|------|----|----|----|----|----|
| R4 | 1 | 1 | 0 | 1 | 1 |
| R3 | 0 | 1 | 0 | 1 | 1 |
| R2 | 0 | 1 | 0 | 0 | 1 |
| R1 | 0 | 1 | 0 | 0 | 0 |
| N | 0 | 0 | 0 | 0 | 0 |
| F1 | 0 | 0 | 1 | 0 | 0 |
| F2 | 0 | 0 | 1 | 0 | 1 |
| F3 | 0 | 0 | 1 | 1 | 1 |
| F4 | 1 | 0 | 1 | 1 | 1 |
| F5 | 1 | 0 | 1 | 1 | 0 |
| F6 | 1 | 1 | 1 | 1 | 0 |
| F7 | 1 | 1 | 1 | 0 | 0 |
| F8 | 1 | 1 | 1 | 0 | 1 |

Mit einem Code, der derartige Merkmale aufweist, läßt sich ein mit dem Kodierer verbundenes Getriebesteuersystem derart ausbilden, daß bei Vorliegen eines elektrischen Fehlers, wie ein Leitungskurzschluß oder eine Leitungsunterbrechung in irgend einer (jedoch lediglich in einer) der Leitungen 20 - 28 oder ein Fehler in irgend einem (aber lediglich einem) der fünf Bits, ein Gangwechsel, sofern gewünscht, lediglich in einen benachbarten Gang oder in die neutrale Stellung vorgenommen wird. Ein Sprung über mehrere Gangstufen hinweg ist hingegen nicht möglich.

Auch wenn die Erfindung lediglich an Hand eines Ausführungsbeispieles beschrieben wurde, das zum gegenwärtigen Zeitpunkt als die bevorzugteste Ausführungsart angesehen wird, erschließen sich für den Fachmann im Lichte der vorstehenden Beschreibung viele verschiedenartige Alternativen, Modifikationen und Varianten, die unter die vorliegende Erfindung fallen.

Beispielsweise kann an Stelle eines Kodierelementes vom magnetischen Typ mit der beschriebenen Sensoranordnung ein optischer Sensor in Verbindung mit einem Kodierelement verwendet werden, welches Bereiche unterschiedlichen Reflexionsvermögens oder unterschiedlicher Durchlässigkeit aufweist, wie sie bei bekannten Kodieranordnungen verwendet werden. Es können auch auf Magnetfelder ansprechende Sensoren in Verbindung mit magnetischen Kodierelementen oder mechanische Schalter mit baulichen Kodierelementen verwendet werden.

Es lassen sich auch andere Sätze von Wörtern, die einen Gray-Code bilden und die oben beschriebenen Eigenschaften aufweisen, formulieren. Beispielsweise läßt sich ein alternativer Code dadurch formulieren, daß die in den Figuren 2 und 3 dargestellten Kodescheiben umgruppiert werden. Ferner kann auch ein Gray-Code verwendet werden, der entsprechend der Anzahl der zu kodierenden Lagen weniger oder mehr als fünf Bits enthält.

Alle die hier angedeuteten Ausgestaltungen sollen von dem Patentanspruch mitumfaßt sein.

4

**Patentansprüche**

1. Lagekodierer zum Nachweis der Lage eines Teiles (12), welches zwischen mehreren Lagen bewegbar ist, mit mehreren Kodierelementen (30 - 38), die Kennungen aufweisen, welche eine Vielzahl aus mehreren Bits gebildeter Wörter eines Gray-Codes, die jeweils einer bestimmten Lage entsprechen, repräsentieren, wobei jedes Wort einmalig ist und nur einer der Lagen entspricht, dadurch gekennzeichnet, daß die Kennungen so angeordnet sind, daß für jedes Wort des Codes durch Änderung lediglich eines Bits des die besondere Lage repräsentierenden Wortes ein Wort entsteht, das
   a) identisch mit einem Wort ist, das eine Lage des bewegbaren Teiles repräsentiert, die unmittelbar benachbart zu der besonderen Lage ist, oder
   b) sich von allen Wörtern, die eine mögliche Lage repräsentieren, unterscheidet.

*FIG. 1*

*FIG. 2*

FIG. 3a

FIG. 3b

FIG. 3c

FIG. 3d

FIG. 3e